(19) Europäisches Patentamt
European Patent Office
Office européen des brevets

(11) **EP 4 641 230 A1**

(12) **EUROPEAN PATENT APPLICATION**
published in accordance with Art. 153(4) EPC

(43) Date of publication:
**29.10.2025 Bulletin 2025/44**

(21) Application number: **24762938.9**

(22) Date of filing: **30.01.2024**

(51) International Patent Classification (IPC):
**G01R 31/367** (2019.01)

(52) Cooperative Patent Classification (CPC):
**G01R 31/367; G01R 31/396**

(86) International application number:
**PCT/CN2024/074675**

(87) International publication number:
**WO 2024/179255 (06.09.2024 Gazette 2024/36)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **01.03.2023 CN 202310233219**

(71) Applicant: **BYD Company Limited
Shenzhen, Guangdong 518118 (CN)**

(72) Inventors:
• **FENG, Tianyu
Shenzhen, Guangdong 518118 (CN)**
• **SHU, Shiwei
Shenzhen, Guangdong 518118 (CN)**
• **DENG, Linwang
Shenzhen, Guangdong 518118 (CN)**
• **LI, Hengfeng
Shenzhen, Guangdong 518118 (CN)**

(74) Representative: **Taor, Simon Edward William et al
Venner Shipley LLP
200 Aldersgate
London EC1A 4HD (GB)**

(54) **SELF-DISCHARGE BATTERY-CELL IDENTIFICATION METHOD AND APPARATUS**

(57) A self-discharge battery-cell identification method and apparatus, which belong to the technical field of battery monitoring. The method comprises: acquiring historic state parameters of a battery pack (step 1); performing effective data screening on data in the historical state parameters of the battery pack, so as to obtain screened historical state parameters of the battery pack (step 2); on the basis of the screened historical state parameters of the battery pack, determining the ratio of the number of times each battery cell is used as a lowest-voltage battery cell within a preset time period (step 3); and on the basis of the ratio of the number of times of each battery is used as the lowest-voltage battery cell within the preset time period, determining a self-discharge identification result for each battery cell (step 4).

FIG. 1

**Description**

**CROSS-REFERENCE TO RELATED APPLICATIONS**

The present disclosure claims priority to Chinese patent application No. 202310233219.5 filed on March 1, 2023, entitled "METHOD AND APPARATUS FOR IDENTIFYING SELF-DISCHARGE CELL", which is incorporated herein by reference in its entirety.

**TECHNICAL FIELD**

The present disclosure relates to the technical field of battery monitoring, and in particular, to a method for identifying a self-discharge cell, an apparatus for identifying a self-discharge cell, a battery management system, an electronic device, and a readable storage medium.

**BACKGROUND**

At present, safety of power batteries has become a new focus in the development of the new energy vehicle industry. Due to limitations of production processes and other factors, as the usage time increases, a power battery may experience self-discharge caused by internal short circuits, which may lead to problems of reduced available capacity of a vehicle, breakdown during driving, safety hazards under extreme conditions, and the like.

In view of this, the related art, it is proposed to measure and monitor a battery state in real time by using a vehicle-side battery management system, or to upload data of a real-time operating state of the power battery to a big data processing cloud platform, and import the data into a big data processing model built by using machine learning to complete a differentiated management and control strategy of the power battery, thereby achieving more powerful cloud-based collaborative management of the power battery.

However, the direct monitoring and management method described above cannot achieve a large amount of data storage and complex calculation due to environmental constraints, and lacks timeliness and cannot provide early warning because a fault is detected only after it has occurred in a battery pack. Use of a cloud platform processing mode requires a vehicle to be idle for a sufficient period of time and a voltage drop characteristic to be apparent enough, posing a limitation in its application.

**SUMMARY**

An objective of an implementation of the present disclosure is to provide a method for identifying a self-discharge cell to at least solve problems that a direct monitoring and management method described above cannot achieve large amount of data storage and complex calculation due to environmental constraints, and lacks timeliness and cannot provide early warning because a fault is detected only after it has occurred in the battery pack, and use of a cloud platform processing mode requires a vehicle to be idle for a sufficient period of time and voltage drop characteristic to be apparent enough, posing a limitation in its application.

To achieve the foregoing objective, the present disclosure provides a method for identifying a self-discharge cell in a first aspect, the method includes:

obtaining historical state parameters of a battery pack;
performing valid data filtering on data in the historical state parameters of the battery pack to obtain filtered historical state parameters of the battery pack;
determining, based on the filtered historical state parameters of the battery pack, a proportion of a quantity of times each cell has served as a cell with a lowest voltage within a preset time period; and
determining a self-discharge identification result of each cell based on the proportion of the quantity of times each cell has served as the cell with the lowest voltage within the preset time period.

Optionally, the historical state parameters of the battery pack include: a charging state, a current value, a current value and a cell number.

Optionally, the performing valid data filtering on data in the historical state parameters of the battery pack to obtain filtered historical state parameters of the battery pack includes:

marking a position of data, which is in a non-charging state and has an absolute current value less than a preset current threshold, in the historical state parameters of the battery pack as a valid data flag; and
using data groups corresponding to all valid data flags in the historical state parameters of the battery pack as the filtered historical state parameters of the battery pack.

Optionally, the determining a self-discharge identification result of each cell based on the proportion of the quantity of times each cell has served as the cell with the lowest voltage within the preset time period includes:
for each cell:
if the proportion of the quantity of times that each cell has served as the cell with the lowest voltage within the preset time period exceeds a preset proportion threshold, determining that the cell is a self-discharge cell; or if the proportion of the quantity of times that each cell has served as the cell with the lowest voltage within the preset time period does not exceed a preset proportion threshold, determining that the cell is not the self-discharge cell.

Optionally, the method further includes:
displaying the self-discharge identification result of each cell.

A second aspect of the present disclosure provides an apparatus for identifying a self-discharge cell, including:

a data acquisition module, configured to obtain historical state parameters of a battery pack;
a data filtering module, configured to perform valid data filtering on data in the historical state parameters of the battery pack to obtain filtered historical state parameters of the battery pack;
a times proportion determining module, configured to determine, based on the filtered historical state parameters of the battery pack, a proportion of a quantity of times each cell has served as a cell with a lowest voltage within a preset time period; and
a result output module, configured to determine a self-discharge identification result of each cell based on the proportion of the quantity of times each cell has served as the cell with the lowest voltage within the preset time period.

Optionally, the apparatus further includes:
a display module, configured to display the self-discharge identification result of each cell.

A third aspect of the present disclosure provides a battery management system, including the apparatus for identifying a self-discharge cell described above.

A fourth aspect of the present disclosure provides an electronic device, including a memory, a processor, and a computer program stored in the memory and executable on the processor, where the processor, when executing the computer program, is configured to implement the method for identifying a self-discharge cell described above.

In addition, the present disclosure provides a readable storage medium having an instruction stored thereon, the instruction is used to make a machine execute the method for identifying a self-discharge cell described above.

According to the technical solution, self-discharge of a cell can be analyzed and determined through historical state parameters of a battery pack, instead of using real-time data for monitoring and early warning. This technical solution has the advantages of small data volume, simple method, and an ability to achieve early and accurate identification. A possible cell with abnormal self-discharge can be identified without requiring prolonged storage or special working conditions, offering broader application potential.

Other features and advantages of implementations of the present disclosure are described in detail in the following specific implementations.

## BRIEF DESCRIPTION OF DRAWINGS

The accompanying drawings, which are used to provide a further understanding of implementations of the present disclosure and constitute a part of this specification, are used together with the following specific implementations to explain the implementations of the present disclosure, which do not constitute a limitation on the implementations of the present disclosure. In the drawings:

FIG. 1 is a flowchart of a method for identifying a self-discharge cell according to the present disclosure;
FIG. 2 is a flowchart of data validity filtering according to the present disclosure;
FIG. 3 is a block diagram of a method for identifying a self-discharge cell according to the present disclosure;
FIG. 4 is a diagram of a structure of an apparatus for identifying a self-discharge cell according to the present disclosure;
FIG. 5 is a diagram of a structure of a battery management system according to the present disclosure;
FIG. 6 is a diagram of a structure of an electronic device according to the present disclosure;
FIG. 7 is a diagram of a structure of a readable storage medium according to the present disclosure; and
FIG. 8 is a diagram showing a trend of a proportion change of a quantity of times a self-discharge cell has served as a cell with a lowest voltage within a preset time period according to the present disclosure.

## Reference numerals:

10: data acquisition module; 20: data filtering module; 30: times proportion determining module; 40: result output module;
100: apparatus for identifying self-discharge cell;
500: battery management system; 600: electronic device; 700: readable storage medium;
601: memory; 602: processor.

## DESCRIPTION OF EMBODIMENTS

The following is a detailed description of specific implementations of the present disclosure with reference to the accompanying drawings. It should be understood that specific implementations described herein are merely intended to illustrate and explain the present disclosure but not to limit the present disclosure.

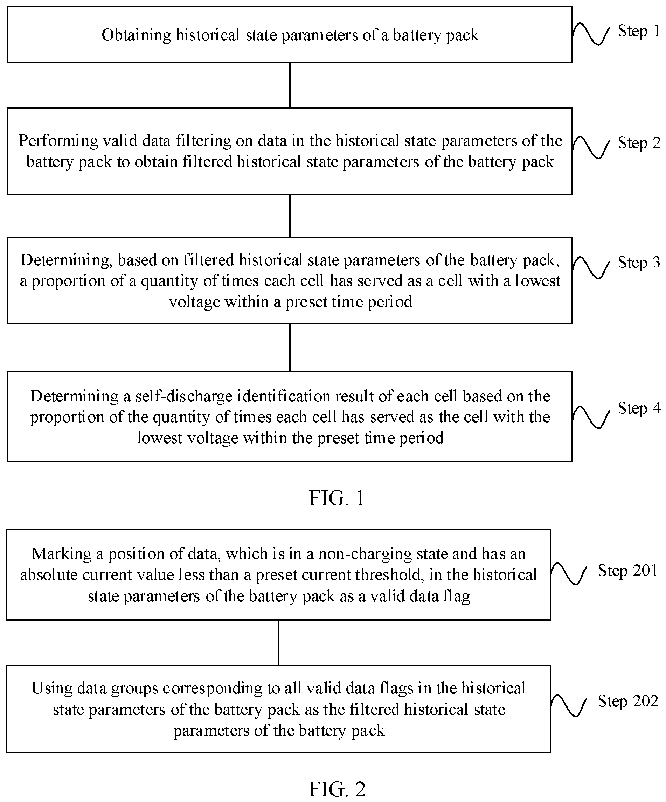

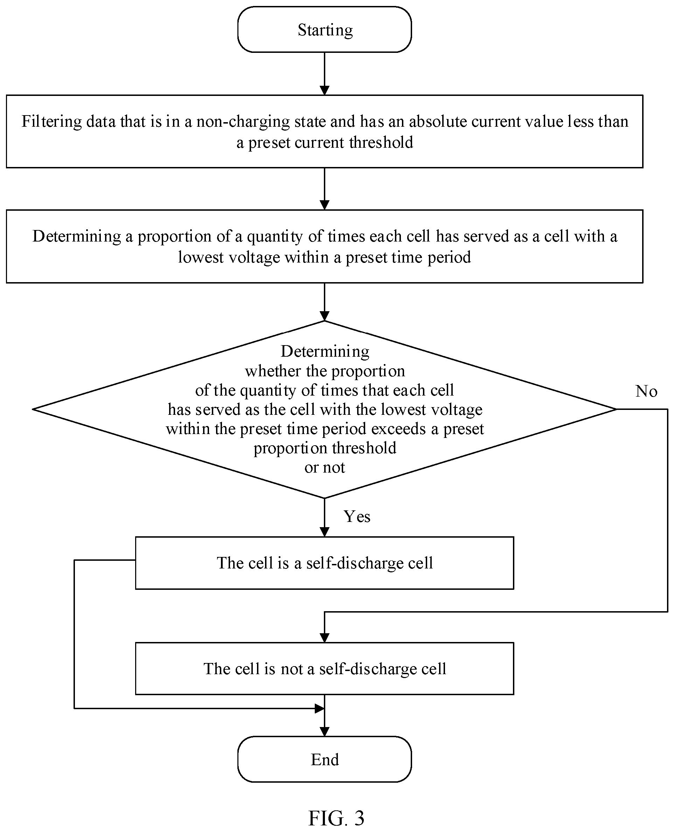

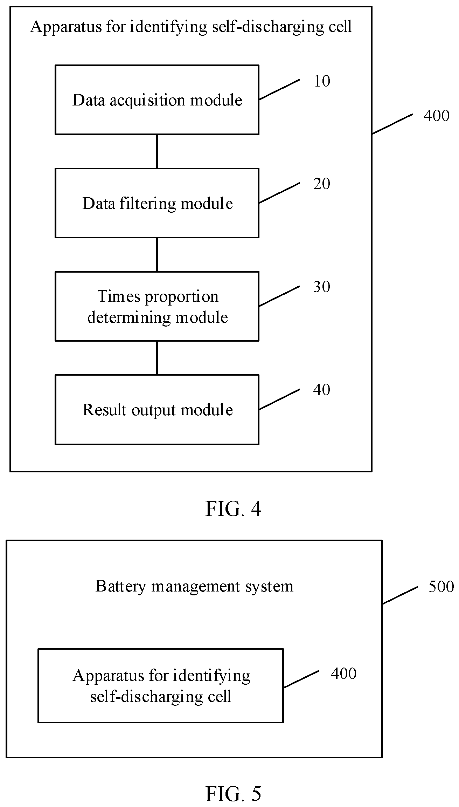

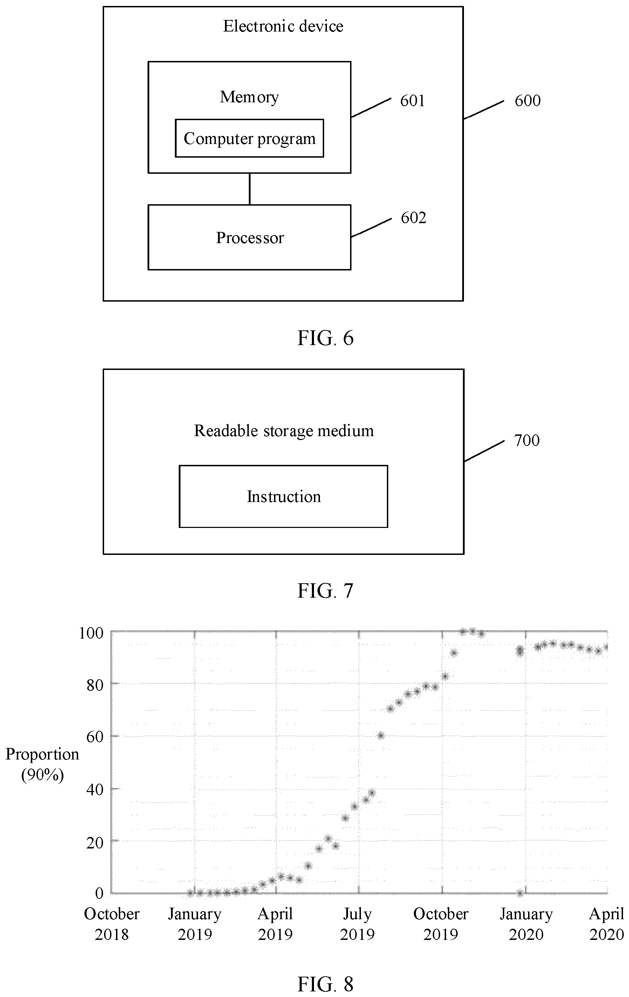

FIG. 1 is a flowchart of a method for identifying a self-discharge cell according to the present disclosure. FIG. 2 is a flowchart of data validity filtering according to the present disclosure. FIG. 3 is a block diagram of a method for identifying a self-discharge cell according to the present disclosure. FIG. 4 is a diagram of a structure of an apparatus for identifying a self-discharge cell according to the present disclosure. FIG. 5 is a diagram of a structure of a battery management system according to the present disclosure. FIG. 6 is a diagram of a structure of an electronic device according to the present disclosure. FIG. 7 is a diagram of a structure of a readable storage medium according to the present disclosure. FIG. 8 is a diagram showing a trend of a proportion change of a quantity of times a self-discharge cell has served as a cell with a lowest voltage within a preset time period according to the present disclosure.

Embodiment 1

As shown in FIG. 1 to FIG. 3, an implementation of the present disclosure provides a method for identifying a self-discharge cell, including the following steps.

Step 1: Obtain historical state parameters of a battery pack.

Specifically, the historical state parameters of the battery pack include: SOC (State of Charge, state of charge), a charging state, a current value, a voltage value, and a cell number. Usually, the battery pack includes a plurality of cells connected in series and/or in parallel, and each cell has a unique cell number. Therefore, all cells in a same battery pack have a same charging state, and may be in a charging state or a non-charging state. However, there are some differences in corresponding current values and voltage values of cells in different positions. Therefore, there is definitely a cell with a specific cell number exhibiting a lowest voltage value among all cells. In addition, the historical state parameters of the battery pack include data groups at a plurality of sampling moments within a historical period of time. Each data group includes charging states (initial data obtained by sampling), current values (initial data obtained by sampling), voltage values (initial data obtained by sampling) and cell numbers (preset attribute data of the battery pack) of all cells at different sampling moments.

Step 2. Perform valid data filtering on data in the historical state parameters of the battery pack to obtain filtered historical state parameters of the battery pack.

Specifically, in this implementation, after the historical state parameters of the battery pack are obtained, the following steps are used to perform valid data filtering on the data group in the historical state parameters of the battery pack according to the charging state and the current value in the historical state parameters of the battery pack, including the following steps.

Step 201: Mark a position of data position, which is in a non-charging state and has an absolute current value less than a preset current threshold, in the historical state parameters of the battery pack as a valid data flag.

Step 202: Use data groups corresponding to all valid data flags in the historical state parameters of the battery pack as the filtered historical state parameters of the battery pack.

More specifically, in this implementation, a data group in the data position, which is in the non-charging state and has the absolute current value less than 3A, among all the data is used as the valid data, and the position of data is marked as the valid data flag, while a position of data without the valid data flag is invalid data and is removed. Finally, remaining valid data groups with the valid data flags are summarized as the filtered historical state parameters of the battery pack.

Step 3: Determine, based on the filtered historical state parameters of the battery pack, a proportion of a quantity of times each cell has served as a cell with a lowest voltage within a preset time period is determined.

Specifically, in this implementation, the invalid data is cleaned and removed through the foregoing Step 2 to finally obtain the filtered historical state parameters of the battery pack including valid data groups. In this way, among the filtered historical state parameters of the battery pack, the data may be non-continuous data according to an order of data sampling moments. Therefore, the filtered historical state parameters of the battery pack are segmented according to a time length of the preset time period to obtain a plurality of data segments, and in data segments where no data removal is performed or where a same amount of data is removed, a total number of valid data groups remains identical, while in data segments with different amounts of data removed, a total number of valid data groups is different, but the data group corresponding to each sampling moment in each data segment includes cell numbers and voltage values corresponding to all cells. Therefore, a cell number of the cell with the lowest voltage in the data group corresponding to each sampling moment can be determined first, and then a quantity of times each cell in each data segment has served as a cell with a lowest voltage at all sampling moments in the data segment can be counted separately, and a ratio of the quantity of times to the total number of valid data groups in this data segment is calculated to determine a proportion of a quantity of times the cell has served as the cell with the lowest voltage within the preset time period.

More specifically, in this implementation, historical state parameters of a vehicle battery pack for risk assessment of a past year are read, and after the valid data filtering is performed on the historical state parameters of the battery pack, the filtered historical state parameters of the battery pack are segmented according to a time length of the preset time period (taking that a window length of the preset time period is 31 days and an interval of sampling moments is one day as an example) to obtain 12 data segments, where the data segment within a time range of 2022/05/01 to 2022/06/01 is statistically analyzed, and 2:00 p.m. at noon every day is used as the sampling moment, data groups corresponding to 31 sampling moments in this data segment are obtained. Among these 31 groups of data, only 21 groups of data meet a condition that the battery pack is in a non-charging state and has an absolute current value less than a preset current threshold (remaining 10 groups of data do not meet filtering conditions and are removed), and in these 21 groups of data, a cumulative quantity of times a 100-th cell has served as the cell with the lowest voltage is 19, and a corresponding proportion of the quantity of times the 100-th cell has served as the cell with the lowest voltage within the preset time period is:

$$P = (19/21) \times 100\% = 90.5\%.$$

Step 4: Determine self-discharge identification result of each cell based on the proportion of the quantity of times that each cell has served as the cell with the lowest voltage within the preset time period.

Specifically, in this implementation, the self-discharge identification result of the cell includes that the cell is a self-discharge cell, as well as the cell is not the self-discharge cell.

For each cell, the proportion of the quantity of times each cell has served as the cell with the lowest voltage within the preset time period is calculated through the foregoing Step 3.

If the calculated proportion of the quantity of times the cell has served as the cell with the lowest voltage exceeds a preset proportion threshold within the preset time period, it may be determined that the cell is a self-discharge cell; and

if the calculated proportion of the quantity of times the cell has served as the cell with the lowest voltage does not exceed the preset proportion threshold within the preset time period, it is determined that the cell is not the self-discharge cell.

The preset proportion threshold may be determined by fitting analysis of the historical state parameters of the battery pack or directly determined based on experience.

In some other implementations, the method further includes the following steps.

Display the self-discharge identification result of each cell.

Specifically, after the self-discharge identification result of each cell is obtained through the foregoing technical solution, the self-discharge identification result of the cell is displayed to achieve further utilization of the self-discharge identification result of the cell. The self-discharge identification result of each cell is displayed by using a sound apparatus and/or a light-emitting apparatus and/or a display apparatus. The foregoing apparatuses are mainly configured to intuitively display the self-discharge identification result obtained by the foregoing method, and one or more apparatuses can be selected for use or used in combination according to actual conditions.

More specifically, in this implementation, the sound apparatus and/or light-emitting apparatus and/or display apparatus may include at least: an automotive dashboard, a central control display screen, a mobile terminal in communication with a vehicle, and a server side in communication with the vehicle. After the self-discharge identification result of each cell is obtained, the self-discharge identification result of the cell is displayed according to the cell number of the cell. For example: for a cell that is identified as the self-discharge cell in the self-discharge identification result, the cell number of the cell is displayed on the automotive dashboard and/or the central control display screen and/or the mobile terminal in communication with the vehicle and/or the server side in communication with the vehicle, and an alarm (such as an audible and visual alarm, etc.) is generated to remind a user to inspect and replace the battery pack.

Through the foregoing method for identifying a self-discharge cell of the present disclosure, the purpose of identifying and warning a faulty cell in advance can be achieved based on the calculation of the historical state parameter data of a vehicle battery. Special working condition data such as prolonged storage is not required, and underreporting caused by the lack of valid working condition data can be reduced. Compared with other existing fault warning methods, a result is calculated by an algorithm based on the historical state parameter data of the vehicle battery, rather than real-time monitoring and warning. A possible cell with abnormal self-discharge can be identified without requiring prolonged storage or special working conditions, and the calculation method is simple and has great application prospects.

Embodiment 2

As shown in FIG. 4, an implementation of the present disclosure provides an apparatus 400 for identifying a self-discharge cell, where the apparatus 400 includes:

a data acquisition module 10, configured to obtain historical state parameters of a battery pack;

a data filtering module 20, configured to perform valid data filtering on data in the historical state parameters of the battery to obtain filtered historical state parameters of the battery pack;

a times proportion determining module 30, configured to determine, based on the filtered historical state parameters of the battery pack, a proportion of a quantity of times each cell has served as a cell with a lowest voltage within a preset time period ; and

a result output module 40, configured to determine a self-discharge identification result of each cell based on the proportion of the quantity of times that each cell has served as the cell with the lowest voltage within the preset time period.

In some embodiments, the historical state parameters of the battery pack include: a charging state, a current value, a voltage value, and a cell number.

In some embodiments, the data filtering module 20 includes:

a data marking unit, configured to mark a position of data, which is in a non-charging state and has an absolute current value less than a preset current threshold, in the historical state parameters of the battery pack as a valid data flag; and
a data filtering unit, configured to use data groups corresponding to all valid data flags in the historical state parameters of the battery pack as the filtered historical state parameters of the battery pack.

In some embodiments, the result output module 40 is specifically configured to:
for each cell:
determine that the cell is a self-discharge cell if the proportion of the quantity of times that the cell has served as the cell with the lowest voltage exceeds a preset proportion threshold within the preset time period; or determine that the cell is not the self-discharge cell if the proportion of the quantity of times that the cell has served as the cell with the lowest voltage does not exceed the preset proportion threshold within the preset time period.

In some embodiments, the apparatus 400 further includes:
a display module, configured to display the self-discharge identification result of each cell.

Embodiment 3

As shown in FIG. 5, an implementation of the present disclosure further provides a battery management system 500 (Battery Management System BMS), which includes the apparatus 400 for identifying a self-discharge cell described above.

Embodiment 4

As shown in FIG. 6, an implementation of the present disclosure further provides an electronic device 600, including a memory 601, a processor 602, and a computer program stored in the memory 601 and executable on the processor 602, where the processor 602, when executing the computer program, is configured to implement the method for identifying a self-discharge cell described above.

Embodiment 5

As shown in FIG. 7, an implementation of the present disclosure further provides a readable storage medium 700, an instruction is stored on the readable storage medium 700, and the instruction is used to make a machine execute the method for identifying a self-discharge cell described above.

Embodiment 6

In this implementation, taking a specific model of test vehicle as an example, historical state parameters of a battery pack of the vehicle from January 2019 to April 2020 are read, which include: a corresponding charging state and current value of each data storage node, and data of a cell with a lowest voltage in the battery pack. Validity filtering is performed on data in the foregoing historical state parameters of the battery pack, and all data that are in a non-charging state and have an absolute current value less than 3A are filtered as basic data for subsequent analysis and determination. In this implementation, with each week as a complete preset time period, one of the cells is subjected to data statistical analysis to obtain a quantity of times the cell has served as a cell with a lowest voltage in different preset time periods, and a proportion of a quantity of times the cell has served as the cell with the lowest voltage within each preset time period to a total amount of data within the preset time period is used as a proportion of a quantity of times the cell has served as the cell with the lowest voltage, thereby obtaining a graph showing a trend of a proportion change of the quantity of times the self-discharge cell has served as the cell with the lowest voltage within the preset time period shown in FIG. 8. In addition, in this implementation, the preset proportion threshold is set to 90%. It can be clearly concluded from FIG. 8 that with the passage of time the proportion of the quantity of times that the cell has served as the cell with the lowest voltage in each statistical window period since November 2019 is greater than the preset proportion threshold (90%), and it can be determined that the cell is the self-discharge cell.

Those skilled in the art may appreciate that all or part of the steps in the method for implementing the foregoing implementations can be completed by instructing related hardware through a program, which is stored in a storage medium and includes a quantity of instructions for enabling a single-chip microcomputer, a chip or a processor (processor) to execute all or part of the steps of the method described in each implementation of the present disclosure. The foregoing storage medium includes any medium that can store program code, such as a USB flash drive, a mobile hard disk, a read-only memory (ROM, Read-Only Memory), a random access memory (RAM, Random Access Memory), a magnetic disk, or an optical disc.

Optional implementations of the present disclosure are described in detail above in conjunction with the accompanying drawings. However, the implementations of the present disclosure are not limited to specific details in the foregoing implementations. Within the technical concept of the implementations of the present disclosure, various simple modifications can be made to the technical solutions of the implementations of the present disclosure, and these simple modifications all belong to the scope of protection of the implementations of the present disclosure. It should also be noted that various specific technical features described in the foregoing specific implementations can be combined in any appropriate manner without contradiction. To avoid unnecessary repetition, the present disclosure will not further explain various possible combinations.

In addition, various implementations of the present disclosure may be arbitrarily combined as long as they do not violate the concept of implementations of the present disclosure, which should also be considered as the contents disclosed in implementations of the present disclosure.

**Claims**

1. A method for identifying a self-discharge cell, wherein the method comprises:

   obtaining historical state parameters of a battery pack;
   performing valid data filtering on data in the historical state parameters of the battery pack to obtain filtered historical state parameters of the battery pack;
   determining, based on the filtered historical state parameters of the battery pack, a proportion of a quantity of times each cell has served as a cell with a lowest voltage within a preset time period; and
   determining a self-discharge identification result of each cell based on the proportion of the quantity of times each cell has served as the cell with the lowest voltage within the preset time period.

2. The method for identifying a self-discharge cell according to claim 1, wherein the historical state parameters of the battery pack comprise a charging state, a current value, a voltage value, and a cell number.

3. The method for identifying a self-discharge cell according to claim 2, wherein the performing valid data filtering on data in the historical state parameters of the battery pack to obtain filtered historical state parameters of the battery pack comprises:

   marking a position of data, which is in a non-charging state and has an absolute current value less than a preset current threshold, in the historical state parameters of the battery pack as a valid data flag; and
   using data groups corresponding to all valid data flags in the historical state parameters of the battery pack as the filtered historical state parameters of the battery pack.

4. The method for identifying a self-discharge cell according to any one of claims 1 to 3, wherein the determining a self-discharge identification result of each cell based on the proportion of the quantity of times each cell served as the cell with the lowest voltage within the preset time period comprises:
for each cell:
if the proportion of the quantity of times that each cell has served as the cell with the lowest voltage within the preset time period exceeds a preset proportion threshold, determining that the cell is a self-discharge cell; or if the proportion of the quantity of times that each cell has served as the cell with the lowest voltage within the preset time period does not exceed a preset proportion threshold, determining that the cell is not the self-discharge cell.

5. The method for identifying a self-discharge cell according to any one of claims 1 to 4, wherein the method further comprises:
displaying the self-discharge identification result of each cell.

6. An apparatus for identifying a self-discharge cell (400), wherein the apparatus (400) comprises:

   a data acquisition module (10), configured to obtain historical state parameters of a battery pack;
   a data filtering module (20), configured to perform valid data filtering on data in the historical state parameters of the battery pack to obtain filtered historical state parameters of the battery pack;
   a times proportion determining module (30), configured to a determine, based on the filtered historical state parameters of the battery pack, a proportion of a quantity of times each cell has served as a cell with a lowest voltage within a preset time period; and
   a result output module (40), configured to determine a self-discharge identification result of each cell based on the proportion of the quantity of times that each cell has served as the cell with the lowest voltage within the preset time period.

7. The apparatus for identifying a self-discharge cell (400) according to claim 6, wherein the apparatus (400) further comprises:
a display module, configured to display the self-discharge identification result of each cell.

8. A battery management system (500), comprising the apparatus (400) for identifying a self-discharge cell according to any one of claims 6 and 7.

9. An electronic device (600), comprising: a memory (601), a processor (602), and a computer program stored in the memory (601) and executable on the processor (602), wherein the processor (602), when executing the computer program, is configured to implement the method for identifying a self-discharge cell according to any one of claims 1 to 5.

10. A readable storage medium (700), wherein an instruction is stored on the readable storage medium (700), and the instruction is configured to make a machine execute the method for identifying a self-discharge cell according to any one of claims 1 to 5.

| Obtaining historical state parameters of a battery pack | Step 1 |

| Performing valid data filtering on data in the historical state parameters of the battery pack to obtain filtered historical state parameters of the battery pack | Step 2 |

| Determining, based on filtered historical state parameters of the battery pack, a proportion of a quantity of times each cell has served as a cell with a lowest voltage within a preset time period | Step 3 |

| Determining a self-discharge identification result of each cell based on the proportion of the quantity of times each cell has served as the cell with the lowest voltage within the preset time period | Step 4 |

FIG. 1

| Marking a position of data, which is in a non-charging state and has an absolute current value less than a preset current threshold, in the historical state parameters of the battery pack as a valid data flag | Step 201 |

| Using data groups corresponding to all valid data flags in the historical state parameters of the battery pack as the filtered historical state parameters of the battery pack | Step 202 |

FIG. 2

```
                    ┌─────────────────────┐
                    │      Starting        │
                    └─────────────────────┘
                               │
                               ▼
    ┌──────────────────────────────────────────────────────────────┐
    │ Filtering data that is in a non-charging state and has an     │
    │ absolute current value less than a preset current threshold   │
    └──────────────────────────────────────────────────────────────┘
                               │
                               ▼
    ┌──────────────────────────────────────────────────────────────┐
    │ Determining a proportion of a quantity of times each cell has │
    │ served as a cell with a lowest voltage within a preset time    │
    │ period                                                         │
    └──────────────────────────────────────────────────────────────┘
                               │
                               ▼
                      ◇ Determining
                  whether the proportion
               of the quantity of times that each cell        No
              has served as the cell with the lowest voltage ─────┐
              within the preset time period exceeds a preset      │
                    proportion threshold                          │
                         or not                                   │
                               │                                  │
                              Yes                                 │
                               ▼                                  │
    ┌──────────────────────────────────────────────────────┐     │
    │           The cell is a self-discharge cell           │     │
    └──────────────────────────────────────────────────────┘     │
                               │                                  │
                               ▼                                  │
    ┌──────────────────────────────────────────────────────┐     │
    │         The cell is not a self-discharge cell         │◀────┘
    └──────────────────────────────────────────────────────┘
                               │
                               ▼
                    ┌─────────────────────┐
                    │         End          │
                    └─────────────────────┘
```

FIG. 3

Apparatus for identifying self-discharging cell

Data acquisition module — 10

Data filtering module — 20

Times proportion determining module — 30

Result output module — 40

400

FIG. 4

Battery management system — 500

Apparatus for identifying self-discharging cell — 400

FIG. 5

## Electronic device

### Memory ⟋ 601 ⟋ 600

#### Computer program

### Processor ⟋ 602

**FIG. 6**

## Readable storage medium ⟋ 700

### Instruction

**FIG. 7**

Proportion (90%)

**FIG. 8**

## INTERNATIONAL SEARCH REPORT

| International application No. |
| --- |
| **PCT/CN2024/074675** |

| **A.** | **CLASSIFICATION OF SUBJECT MATTER** |
| --- | --- |

G01R31/367(2019.01)i

According to International Patent Classification (IPC) or to both national classification and IPC

| **B.** | **FIELDS SEARCHED** |
| --- | --- |

Minimum documentation searched (classification system followed by classification symbols)

IPC:G01R

Documentation searched other than minimum documentation to the extent that such documents are included in the fields searched

Electronic data base consulted during the international search (name of data base and, where practicable, search terms used)

CNTXT, CNKI, ENTXTC, DWPI, ENTXT, VEN: 电池, 自放电, 历史, 筛选, 清洗, 单体, 电芯, 节号, 编号, 电压, 最低, 最小, 次数, 占比, 比率, 阈值, 静置, 电流, battery, self-discharge, history, screening, single, cell, number, voltage, minimum, Min, lowest, ratio, threshold, limit

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| Y | CN 115593232 A (CHONGQING CHANG'AN NEW ENERGY AUTOMOBILE TECHNOLOGY CO., LTD.) 13 January 2023 (2023-01-13) description, paragraphs 0006-0059, and figure 1 | 1-10 |
| Y | CN 109709485 A (CH-AUTO TECHNOLOGY CO., LTD.) 03 May 2019 (2019-05-03) description, paragraphs 0006-0024, and figures 1-2 | 1-10 |
| A | CN 115327417 A (VOYAH AUTOMOBILE TECHNOLOGY CO., LTD.) 11 November 2022 (2022-11-11) entire document | 1-10 |
| A | CN 114636930 A (ZHENGZHOU YUTONG BUS CO., LTD.) 17 June 2022 (2022-06-17) entire document | 1-10 |
| A | CN 112986850 A (BEIJING CHJ INFORMATION TECHNOLOGY CO., LTD.) 18 June 2021 (2021-06-18) entire document | 1-10 |

✓ Further documents are listed in the continuation of Box C.  ✓ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **10 May 2024** | **16 May 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**EP 4 641 230 A1**

## INTERNATIONAL SEARCH REPORT

International application No.

**PCT/CN2024/074675**

### C. DOCUMENTS CONSIDERED TO BE RELEVANT

| Category* | Citation of document, with indication, where appropriate, of the relevant passages | Relevant to claim No. |
|---|---|---|
| A | CN 111873852 A (GUANGZHOU XIAOPENG MOTORS TECHNOLOGY CO., LTD.) 03 November 2020 (2020-11-03)<br>entire document | 1-10 |
| A | CN 113219361 A (SHANGHAI PYLON TECHNOLOGIES CO., LTD.) 06 August 2021 (2021-08-06)<br>entire document | 1-10 |
| A | CN 114430080 A (CHINA AUTOMOTIVE ENGINEERING RESEARCH INSTITUTE CO., LTD.) 03 May 2022 (2022-05-03)<br>entire document | 1-10 |
| A | CN 114441968 A (BEIJING CHJ AUTOMOTIVE TECHNOLOGY CO., LTD.) 06 May 2022 (2022-05-06)<br>entire document | 1-10 |
| A | CN 115219903 A (CHINA FAW CO., LTD.) 21 October 2022 (2022-10-21)<br>entire document | 1-10 |
| A | WO 2023005436 A1 (SVOLT ENERGY TECHNOLOGY CO., LTD.) 02 February 2023 (2023-02-02)<br>entire document | 1-10 |

Form PCT/ISA/210 (second sheet) (July 2022)

14

**INTERNATIONAL SEARCH REPORT**
Information on patent family members

International application No.

**PCT/CN2024/074675**

| Patent document cited in search report | | | Publication date (day/month/year) | Patent family member(s) | Publication date (day/month/year) |
|---|---|---|---|---|---|
| CN | 115593232 | A | 13 January 2023 | None | |
| CN | 109709485 | A | 03 May 2019 | None | |
| CN | 115327417 | A | 11 November 2022 | None | |
| CN | 114636930 | A | 17 June 2022 | None | |
| CN | 112986850 | A | 18 June 2021 | None | |
| CN | 111873852 | A | 03 November 2020 | None | |
| CN | 113219361 | A | 06 August 2021 | None | |
| CN | 114430080 | A | 03 May 2022 | None | |
| CN | 114441968 | A | 06 May 2022 | None | |
| CN | 115219903 | A | 21 October 2022 | None | |
| WO | 2023005436 | A1 | 02 February 2023 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310233219